# EUROPEAN PATENT APPLICATION

(11) **EP 2 629 426 A1**
(43) Date of publication of application: **21.08.2013**
(21) Application number: 12156092.4
(22) Date of filing: 17.02.2012
(51) Int. Cl.: H03M 1/08

(54) **Device, system and method for analogue-to-digital conversion with noise shaping function**

(71) Applicant: IMEC, 3001 Leuven (BE); Renesas Electronics Corporation, Chiyoda-ku Tokyo 100-6334 (JP)
(72) Inventor: Yamamoto, Takaya, Gunma-ken (JP); Craninckx, Jan, 3370 Boutersem (BE)
(74) Representative: Clerix, André

(57) **Abstract**

The invention relates to a device (1') for converting an input analogue current signal (lin) into an output digital signal (Out), comprising: a sample and hold circuit (3) for providing at least one signal related to the input analogue current signal (lin); an analogue-to digital conversion and control circuit (4) for performing an analogue-to-digital conversion of the at least one related signal at the output of the sample and hold module (3) into said output digital signal (Out); and wherein the sample and hold circuit (3) is adapted for sampling and integrating the analogue current signal (lin) on capacitive means (C); the analogue-to-digital conversion and control circuit (4) comprises successive approximation analogue-to-digital conversion means for converting into the digital output signal (Out), during a conversion period, an input charge value (Qin) present in said capacitive means (C); and the sample and hold circuit (3) and the analogue-to-digital conversion and control circuit (4) being configured to add a residue charge (QR), remaining at the end of a conversion of a previous sample of the input charge value (Qin), to a subsequent sample of input charge value (Qin) to be converted.

The invention also relates to a system (1) for converting an input analogue voltage signal (Vin) into an output digital signal (Out), a method for converting an analogue current signal (lin) into a digital signal (Out), and a method for converting an analogue voltage signal (Vin) into a digital signal (Out).

## Description

### Technical Field

The present invention relates to analogue-to-digital conversion and more specifically to a system and method for analogue-to-digital conversion with a noise shaping function.

### Background of the invention

Driven by the increasing demand of new-generation product and high-performance applications which require signal processing at ever-lower power usage, analogue-to-digital converters (ADCs) become an important factor for optimizing the overall system power budget of an electronic device.

As part of the ADC high-performance requirement criteria, noise shaping is an effective technique to achieve high resolution. Its main purpose is to increase the apparent signal to noise ratio of a certain quantized signal by altering the spectral shape of the error that is introduced by quantization and eventually dithering. Document "Noise Shaping Implementation in Two-step/SAR ADC Architectures Based on Delayed Quantization Error", Zhijie Chen et al., 54th IEEE International Midwest Symposium on Circuits and Systems, August 2011, shows an exemplary architecture of a SAR ADC which uses noise shaping, based on delayed analogue quantization error.

A problem with the state of the art techniques for noise shaping applied to SAR ADCs is that they require a complex methodology and circuitry, which need power and add relevant power consumption for analogue-to-digital conversion systems directed to low power applications.

### Summary of the invention

The purpose of the invention is to provide an improved device, system and method for analogue-to-digital conversion which performs noise shaping of the quantization noise and requires low power consumption.

According to one aspect of the present invention, there is provided a device for converting an input analogue current signal into an output digital signal, comprising: a sample and hold circuit for providing at least one signal related to the input analogue current signal; an analogue-to digital conversion and control circuit for performing an analogue-to-digital conversion of the at least one related signal at the output of the sample and hold module into said output digital signal; and wherein the sample and hold circuit is adapted for sampling and integrating the analogue current signal on capacitive means; the analogue-to-digital conversion and control circuit comprises successive approximation analogue-to-digital conversion means for converting into the digital output signal, during a conversion period, an input charge value present in said capacitive means; and the sample and hold circuit and the analogue-to-digital conversion and control circuit being configured to add a residue charge, remaining at the end of a conversion of a previous sample of the input charge value, to a subsequent sample of input charge value to be converted.

The device for analogue-to-digital conversion according to an embodiment of the invention is able to perform noise shaping of the quantization noise such that the noise is reduced in the used signal bandwidth at lower frequencies and increased at high frequencies. Advantageously, the performance of the device for analogue-to-digital conversion can be thereby increased, at least by achieving an effective resolution higher than the number of bits of the ADC, without increasing the system power consumption. Also advantageous is the fact that noise shaping is achieved without increasing the complexity of the analogue-to-digital conversion system.

The invention also relates to a system for converting an input analogue voltage signal into an output digital signal, to an integrated circuit, to a method for converting an analogue voltage signal into a digital signal and to a method for converting an analogue current signal into a digital signal.

Certain objects and advantages of various inventive aspects have been described above. It is to be understood that not necessarily all such objects or advantages may be achieved in accordance with any particular embodiment of the invention. Those skilled in the art will recognize that the invention may be embodied or carried out in a manner that achieves or optimizes one advantage or group of advantages without necessarily achieving other objects or advantages as may be taught or suggested herein. Further embodiments, features, and advantages of the present invention may be described in detail below with reference to the accompanying drawings.

### Brief description of the drawings

The accompanying drawings illustrate one or more exemplary embodiment(s) of the present invention and, together with the description, further serve to explain the principles of the invention and to enable a persona skilled in the art to make and use the invention.
**Figure 1** shows a general block diagram of a first exemplary embodiment of a system for analogue-to-digital conversion according to the present invention.
**Figure 2** shows a general block diagram of a second exemplary embodiment of a system for analogue-to-digital conversion according to the present invention.
**Figure 3** is a schematic representation of an exemplary embodiment of a sample and hold circuit according to the present invention.
**Figure 4A** illustrates a diagram corresponding to a first operation example of a charge-domain successive approximation conversion means of a system for analogue-to-digital conversion according to the invention.
**Figure 4B** illustrates a diagram corresponding to a second operation example of a charge-domain successive approximation conversion means of a system for analogue-to-digital conversion according to the invention.

### Detailed description

In the following, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This is however not to be interpreted as the invention requiring more features than the ones expressly recited in each claim, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those skilled in the art. In the description of the embodiments, numerous specific details are set forth. However, it is understood that embodiments of the invention may be practiced without these non-essential specific details. In other instances, well-known methods, structures and techniques have not been shown in detail in order not to obscure an understanding of this description.

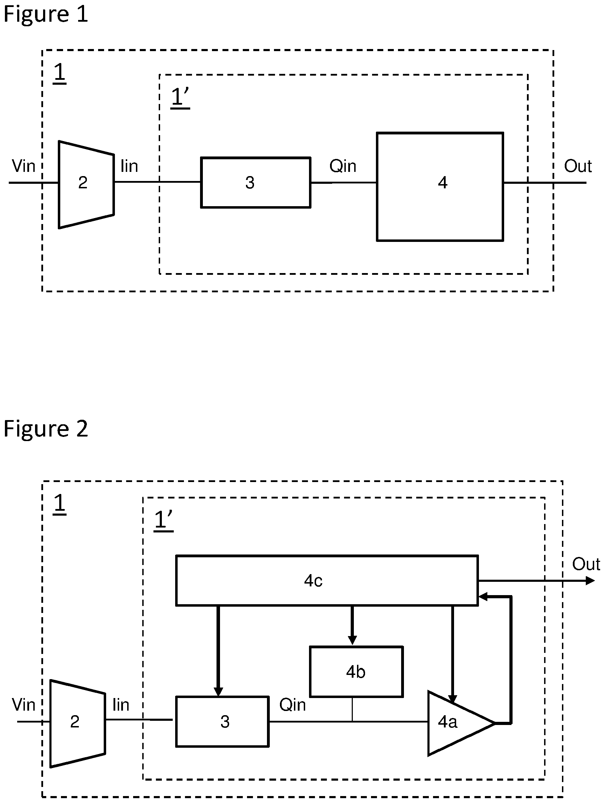

**Figure 1** shows a block diagram of a system **1** for converting an input analogue voltage signal Vin into an output N-bit digital signal **Out,** the system comprising an input interface circuit **2,** a sample and hold circuit **3** and an analogue-to-digital conversion and control circuit **4.**

The input interface circuit **2** is adapted to receive the input analogue voltage signal Vin and comprises voltage-to-current conversion means for converting it into an analogue current signal **lin.** The analogue current signal **lin** is related to that input analogue voltage signal **Vin** in the sense that at least one of its characteristics conveys information about the voltage value of the input voltage analogue signal **Vin.** The voltage-to-current (V/I) conversion means could be implemented for example by one or a plurality of trans-conductors and/or variable-gain trans-conductor cells.

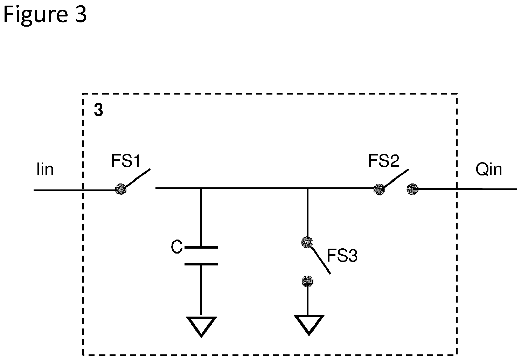

The sample and hold circuit **3** is adapted for receiving and integrating the analogue current signal lin provided by the input interface circuit **2.** A schematic and general representation of the sample and hold circuit **3** can be seen in **Figure 3****.**

According to the invention, the input analogue current signal lin is converted, in the sample and hold circuit **3,** to a charge that is stored in its capacitive means, by integrating that current during a certain time interval on that capacitive means.

The analogue-to-digital conversion and control circuit **4** comprises successive approximation (SA) conversion means for converting the charge stored in the capacitive means of the S/H circuit **3** into the output N-bit digital signal **Out.** The SA conversion steps are based on passive charge-sharing using basically a DAC and a comparator and in which a comparator recognizes the sign of a corresponding differential voltage. A general description on how such SA conversion is performed in the charge-domain can be found in international patent application WO 2008/00675.

**Figure 2** shows another block diagram of an exemplary system **1** for converting an input analogue voltage signal Vin into an output digital signal **Out,** the system comprising an input interface circuit **2,** a sample and hold circuit 3, a comparator **4a,** a passive charge-sharing digital-to-analogue converter **4b** and an asynchronous SAR logic **4c.**

According to an embodiment of the invention, the system **1** uses the charge that is linearly generated by integrating a V/I converter output current. In each of the steps of the successive approximation controller, the sign of the charge is determined by activating the comparator and a binary scaled reference charge is added to or subtracted from the total charge by passive charge sharing.

It shall be understood that although the described system **1** according to an embodiment of the invention combines the functionality of an input interface circuit **2,** a sample and hold circuit **3** and an analogue-to-digital conversion and control circuit **4,** such functionality may be implemented also combining a plurality of independent interconnected devices, each performing one o more functionalities corresponding to the ones disclosed in the present invention. For example, a first device or circuit may be used for performing the V/I conversion function and a second device **1'** may perform a digital conversion of an input analogue current with the functionality of the sample and hold circuit **3** and the analogue-to digital SAR conversion and control circuit **4.**

The system **1** and/or any individual circuits or devices **1**' may be implemented in digital CMOS technology.

**Figure 3** is a schematic representation of an exemplary embodiment of a sample and hold circuit **3,** basically comprising first, second and third switching means **FS1, FS2, FS3** and capacitive means **C.** The switching means could be implemented by any type of switch and the capacitive means by any type of capacitor, such as voltage dependent capacitors, including also MOS capacitors.

The first switching means **FS1** are used to sample the input analogue current signal **lin.** The second switching means **FS2** are used to provide a sample of the voltage and charge on the capacitive means **C** to the analogue-to-digital conversion and control circuit **4** for conversion into the output digital signal **Out.** The third switching means **FS3** may be used to reset the charge still remaining in the capacitive means **C** at the end of the conversion period.

The transfer function from the input voltage to the sampled charge, in this case, shows SINC-filtering. As the input voltage analogue signal **Vin** reaches a frequency close to Nyquist, the attenuation due to the SINC-filtering increases. The quantization noise is flat, spread evenly across the Nyquist bandwidth (fₛ/2) with a total power of LSB²/12.

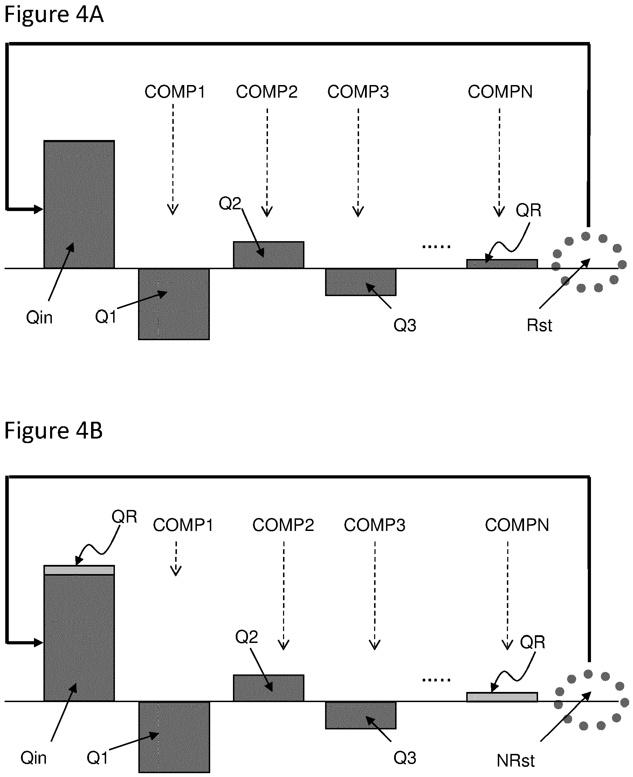

**Figure 4A** illustrates a diagram corresponding to a first operation example of a charge-domain analogue-to-digital conversion and control circuit **4** of a system for analogue-to-digital conversion according to the invention.

According to SAR operation, in each of the steps of the successive approximation controller **COMP1 to COMPN,** a binary scaled reference charge is added to or subtracted from the total charge by passive charge sharing. For example, before the first comparison is performed, the analogue-to-digital conversion and control circuit **4** receives an input charge **Qin** which is a sample of the charge that has been stored in the capacitive means **C** of the S/H circuit **3** during the current integration period. After first comparison **COMP1** the total charge remaining is calculated as **Q1** = Qin - C0 x 512 Qu, where Cn is the n-th most significant bit output code and Qu is the charge unit or the least significant bit (LSB) unit charge. After second comparison **COMP2** the total charge remaining is calculated as **Q2** = Qin - C0 x 512 Qu - C1 x 256 Qu. After third comparison **COMP3** the total charge remaining is calculated as **Q3** = Qin - C0 x 512 Qu - C1 x 256 Qu - C2 x 128 Qu, and so successively until the end of conversion **COMPN,** in which the remaining charge is the difference between the input charge **Qin** and the digital (quantized) estimation of that input, which is called the residue charge **QR.** It shall be noted that the sign of the remaining charge may be positive or negative, and while in some steps it may be added, in others it may be subtracted.

According to an embodiment of the invention, before sampling the next input charge **Qin** on the capacitance means **C** of the sample and hold circuit **3** the capacitance means **C** of the sample and hold circuit **3** is reset **Rst,** so that the residue charge **QR** is discarded before starting a new conversion.

**Figure 4A** illustrates a diagram corresponding to a second operation example of a charge-domain analogue-to-digital conversion and control circuit **4** of a system for analogue-to-digital conversion according to the invention. Instead of discarding the residue charge **QR,** according to an embodiment of the invention, the analogue-to-digital conversion and control circuit **4** does not reset **NRst** the residue charge **QR** remaining on the capacitance means **C** of the sample and hold circuit **3** at the end of the conversion period, so that the residue charge **QR,** in the next S/H current integration period, will be added (or subtracted, depending on the sign of the charge) to the next input charge **Qin.**

The remaining errors, i.e. the residue, add-up and this results in a shaping of the quantization noise towards higher frequencies, such that in the lower part of the input spectrum, the quantization noise floor is reduced. Advantageously an effective resolution higher than the number of bits of the ADC is obtained.

## Claims

1. A device (1') for converting an input analogue current signal (lin) into an output digital signal (Out), comprising:
- a sample and hold circuit (3) for providing at least one signal related to the input analogue current signal (lin);
- an analogue-to digital conversion and control circuit (4) for performing an analogue-to-digital conversion of the at least one related signal at the output of the sample and hold module (3) into said output digital signal (Out); and
**characterized in that**
- the sample and hold circuit (3) is adapted for sampling and integrating the analogue current signal (lin) on capacitive means (C);
- the analogue-to-digital conversion and control circuit (4) comprises successive approximation analogue-to-digital conversion means for converting into the digital output signal (Out), during a conversion period, an input charge value (Qin) present in said capacitive means (C); and
- the sample and hold circuit (3) and the analogue-to-digital conversion and control circuit (4) being configured to add a residue charge (QR), remaining at the end of a conversion of a previous sample of the input charge value (Qin), to a subsequent sample of input charge value (Qin) to be converted.

2. A system (1) for converting an input analogue voltage signal (Vin) into an output digital signal (Out), comprising:
- an input interface circuit (2) for receiving said analogue voltage signal (Vin) and comprising voltage-to-current conversion means for converting the analogue voltage signal (Vin) into an analogue current signal (lin); and
- a device (1') according to claim 1 for converting the analogue current signal (lin) into the output digital signal (Out).

3. An integrated circuit comprising a system (1) for converting an input analogue voltage signal (Vin) into an output digital signal (Out) according to claim 2 or a device (1') for converting an input analogue current signal (lin) into an output digital signal (Out) according to claim 1.

4. A method for converting an analogue current signal (lin) into a digital signal (Out), comprising:
- sampling and integrating the analogue current signal (lin) on capacitive means (C);
- providing to a charge-domain analogue-to-digital converting means (4) a sample of an input charge value (Qin) stored in said capacitive means (C) and said charge-domain analogue-to-digital converting means (4) converting, during a conversion period, said input charge value (Qin) into the digital signal (Out); and
- adding a residue charge (QR), remaining at the end of a conversion of a previous sample of the input charge value (Qin), to a subsequent sample of the input charge value (Qin) to be converted.

5. A method for converting an analogue voltage signal (Vin) into a digital signal (Out), comprising:
- converting the analogue voltage signal (Vin) into an analogue current signal (lin) related to said analogue voltage signal (Vin); and
- converting the analogue current signal (lin) into the digital signal (Out) according to the method of claim 4.
